# EUROPEAN PATENT SPECIFICATION

(11) **EP 2 817 821 B1**
(45) Date of publication and mention of the grant of the patent: **13.05.2020**
(21) Application number: 13701957.6
(22) Date of filing: 22.01.2013
(51) Int. Cl.: H01L 21/677, H01L 21/67, B65G 17/00

(54) **APPARATUS AND METHOD FOR TREATING PLATE-SHAPED PROCESS ITEMS**
VORRICHTUNG UND VERFAHREN ZUR BEHANDLUNG PLATTENFÖRMIGER VERARBEITUNGSGEGENSTÄNDE
APPAREIL ET PROCÉDÉ POUR LE TRAITEMENT DES ÉLÉMENTS DE PROCESSUS EN FORME DE PLAQUE

(30) Priority: 26.01.2012 DE 102012201109; 22.06.2012 DE 102012210618
(43) Date of publication of application: 31.12.2014
(73) Proprietor: Singulus Stangl Solar GmbH, 82256 Fürstenfeldbruck (DE)
(72) Inventor: GRÄFF, Michael, 80798 München (DE); MENSCHICK, Martin Maximilian, 81241 München (DE)
(74) Representative: Stöckeler, Ferdinand
(86) International application number: PCT/EP2013/051091
(87) International publication number: WO 2013/110582

(56) References cited:
- WO-A1-2010/009865

## Description

The present invention relates to apparatuses and methods for treating plate-shaped process items with a process medium, and in particular apparatuses and methods suitable for treating plate-shaped process items, such as wafers used in the production of solar cells, for example semiconductor wafers and in particular silicon wafers.

Semiconductor wafers, in particular polycrystalline, monocrystalline or quasi-monocrystalline semiconductor wafers of a low thickness in a range between 0.1 mm and 0.5 mm, are subject to different process steps during the production of solar cells, including, among others, an etching process, a cleaning process and a drying process.

For transporting semiconductor wafers through different wet areas, methods are known where the wafers are placed on successive rollers, such that one wafer always rests on at least two rollers. These rollers are each driven individually, via mainshafts and bevel gears, spur gears and endless means or the same. As points of support for the wafers, the rollers can comprise O-rings or drums. These drums can consist of absorbent material wetting the wafer with medium. Thereby, the wafers are either transported horizontally or the rollers describe a path on which the rollers are lowered into and out of the media areas. To keep the wafers on track, stop bars or also washer discs can be provided on the rollers. During horizontal transport, the medium streams across the in/outcoming wafers, which ensures a higher media level. In order to prevent floating of the wafers during two-sided processing, down holding systems are used. The same can again be rollers or drums driven separately or not.

EP 1 073 095 A2 discloses a method for cleaning a wafer moved through a cleaning basin by using rollers. WO 2005/093788 A1 discloses methods for one-sided wet chemical treatment of silicon discs by using a liquid bath. Here, the discs rest on transport rollers arranged in the liquid bath, wherein the discs are transported horizontally through the bath by forming and maintaining a meniscus between the discs and a surface of the bath, completely wetted with the liquid within the bath, wherein the level of the liquid contacted by the discs is maintained above the gauge height of the bath surface not contacted by the discs due to the formation of the meniscus.

As an alternative to the roller drives shown in the above-stated references, apparatuses and methods for processing and treating process items are known that operate based on endless means. For example, WO 2008/143518 A1 shows a transport band by means of which wafers are moved through a liquid bath. From WO 2010009865 A1, devices and methods for processing and treating process items are known, comprising a transport means and support elements projecting from the transport means and slide elements. The slide elements engage an edge of the process item to transport the process item through or across a process medium.

Thus, prior art are both drive methods and apparatuses based on rollers arranged successively in process direction, and drive methods and apparatuses comprising at least one endless means, for example a conveyor chain.

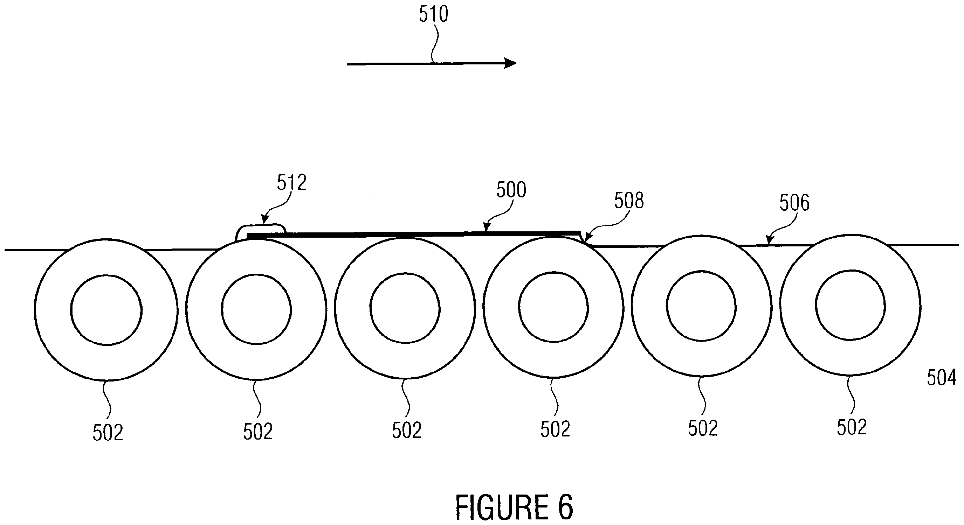

The basic mechanical principle when transporting by means of rollers or drums is the frictional grip as transmission of the driving force from a rotational movement of the rollers or drums to a linear movement of the transport item. The drums or rollers remain stationary, the process item moves in relation thereto. A schematic illustration showing a transport of a process item 500, for example a semiconductor wafer by means of transport rollers 502 is illustrated in Fig. 6. The process item 500 is moved across a process medium 504 comprising a process media level 506 by means of the rollers. Thereby, the height of the rollers 502 in relation to the process media level 506 is set such that a meniscus 508 is formed between process media level 506 and process item 500, by which the process medium 504 is drawn to the bottom side of the process item 500. A transport device is illustrated in Fig. 6 as arrow 510. The arrangement shown in Fig. 6 serves for one-sided (bottom-sided) treatment of the process item 500 including the edges, wherein a comparable procedure is described in the above-stated WO 2005/093788 A1. The inventors have found out that during such one-sided processing, due to the principal relative movement between the transport rollers 502 (which can also be referred to as transport elements or driving elements) and the transported process item 500, it can happen due to a blade effect that the process medium is conveyed to the top side not be treated, wherein a respective wrap-around is illustrated in Fig. 6 at 512. Two-sided processing by using transport rollers requires the usage of so-called downholders for ensuring a sufficient normal force for maintaining the frictional grip. The downholders have a mechanical effect on the surface of the process item which can result in spurious effects, such as banding.

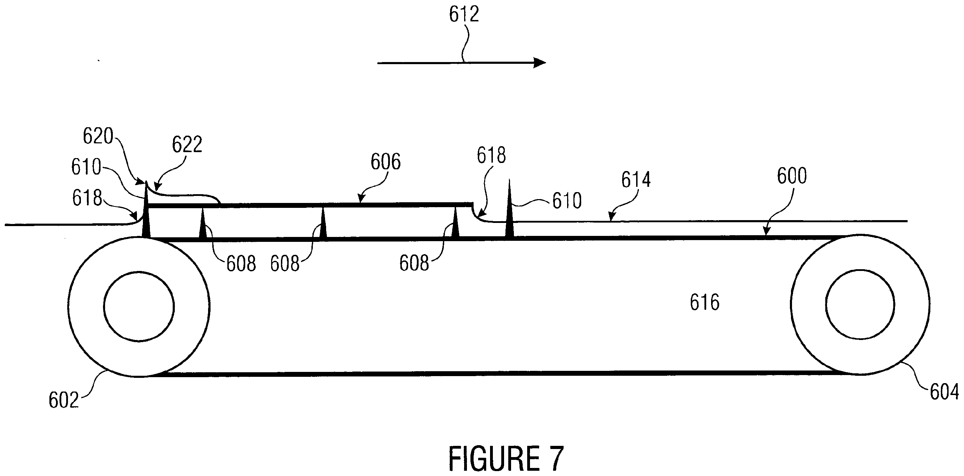

A basic principle of transporting a process item by means of an endless means, such as described, for example in WO 2010/009865 A1, is a form closure in transport direction such that no relative movement between process item and transport element takes place. The inventors have found out that even during such a transport problems with media that can be transported on the top side can occur. For explaining this, Fig. 7 shows a schematic illustration of a transport means. An endless means 600, for example a chain or a belt runs around rollers 602 and 604, wherein one of the rollers is a driven roller. A process item 606 to be transported, for example a semiconductor wafer, rests on support elements 608. Further, slide elements 610 are provided projecting further from the endless means 600 than the support elements 608. The transport direction is illustrated in Fig. 7 as arrow 612.

The height 608 of the support elements in relation to a process media level 614 of a process medium 616 is set such that menisci 618 occur at the edges of the process item 606, by which the process medium 616 is drawn to the bottom of the process item 606. As shown in Fig. 7, the rear slide element 610 in transport direction engages the rear edge of the process item 606. This results in a further meniscus 620 by which the process medium can be drawn to the top of the process item 606, as illustrated by the wraparound at 622 in Fig. 7. The inventors have found out that the force transmission onto the process item 606 by means of a slide element during one-sided processing has the fundamental disadvantage that medium might be transported to the top of the process item that is not to be processed, due to the minimum gap between process item and slide element, or by the engagement between transport item and slide element, by capillary effect and the effect of surface tensions.

Here, it should be noted that the arrangement shown in Fig. 7 presents no prior art, but merely serves for explaining the findings of the inventors underlying the present invention.

It is the object of the present invention to provide apparatuses and methods for treating a plate-shaped process item wherein, in a respective operating mode, the danger of unintentional treatment of a top side of the process item is reduced, as well as to provide a method for producing a semiconductor wafer based thereon.

This object is solved by an apparatus according to claim 1 and methods according to claims 11 and 20.

Embodiments of the invention provide an apparatus for treating a plate-shaped process item comprising a bottom side, a top side and edges between the bottom side and the top side with process media, comprising:
a means for providing a process medium with a process media level;
a transport means comprising an endless means with support elements projecting from the same, on which a bottom side of the plate-shaped process item to be treated can be supported, wherein the transport means is implemented to move the support elements together with the supported plate-shaped process item in parallel to the process media level of the process medium,
wherein the means for providing the process medium and the transport means are adapted for a plate-shaped process item to be treated such that during movement of the plate-shaped process item in parallel to the process media level of the process medium, at least parts of the bottom side of the plate-shaped process item that are not supported on support elements are in contact with the process medium, wherein the transport means is implemented such that during movement of the plate-shaped process item in parallel to the process media level, no parts of the transfer means engage edges of the plate-shaped process item. The first operating mode corresponds to a one side processing treatment of the bottom side of the plate-shaped process item, in which the edges of the plate-shaped process item may be treated or not.

Embodiments of the invention provide a method for treating a plate-shaped process item comprising a bottom side, a top side and edges between the bottom side and the top side, with a process medium by using a transport means comprising an endless means with support elements projecting from the same, comprising;
supporting a bottom side of the plate-shaped process item on support elements of the transport means; and
driving the transport means to move the support elements together with the supported plate-shaped process item in parallel to a process media level of a process medium, wherein at least parts of the bottom side of the plate-shaped process item that are not supported on support elements are in contact with the process medium,
wherein in a first operating mode during movement of the plate-shaped process item in parallel to the process media level no parts of the transport means engage the edges of the plate-shaped process item, wherein the first operating mode corresponds to a one side processing treatment of the bottom side of the plate-shaped process item, in which the edges of the plate-shaped process item may be treated or not.

Embodiments of the present invention are based on the finding that treating a top side of a plate-shaped process item can be reliably prevented when, during a movement of the plate-shaped process item in parallel to the process media level of the process medium, no parts of the transport means engage the edges of the plate-shaped process item. Thereby, capillary effects or surface tension effects tending to transport process medium on the top side can be reduced, which otherwise occur where a slide element engages an edge of the process item.

In other words, in embodiments of the invention, during movement of the plate-shaped process item in parallel to the process media level, no mechanical contact takes place between the transport means and the edges of the plate-shaped process item in an operating mode (in which the top side of the process item is not to be treated). In other words, the edges of the plate-shaped process item remain free from any parts of the transport means during this movement.

In embodiments of the inventive apparatus and the inventive method, in the first operating mode, during movement of the plate-shaped process item in parallel to the process media level in the direction of movement no parts of the transport means are arranged opposite to the edges of the plate-shaped process item at a spacing that is smaller than a contact radius of the process medium due to the surface tension of the same,. In embodiments of the invention, in the first operating mode, during movement of the plate-shaped process item in parallel to the process media level, no parts of the transport means are arranged opposite to the edges of the plate-shaped process item at a spacing that is smaller than 5 mm. By such a spacing between the edges of the process item and any parts of the transport means opposing the edges, capillary effects and effects of surface tensions having the tendency to transport process medium on the top side of the transport item can be reduced further. In embodiments of the invention, such a minimum distance between front and rear edges of the process item in the direction of movement and any parts of the transport means is provided. In embodiments of the invention, such a minimum distance is also provided laterally (transversely to the direction of movement) between lateral edges of the process item and optionally provided limiting means.

In embodiments of the inventive apparatus and the inventive method, in the first operating mode, support elements project such from the process media level that during movement of the plate-shaped process item in parallel to the process media level a meniscus is formed between the plate-shaped process item and the process medium, such that the level of the process medium that is in contact with the bottom side of the plate-shaped process item is above the process media level. Thereby, a suction effect can be exerted on the process item, by which a relative movement between support elements and process item can be prevented. This meniscus is maintained during movement of the process item in parallel to the process media level.

Thus, in embodiments of the present invention, components of forces applied by the process item to the support elements in a direction perpendicular to the main surfaces of the process item are higher than components of forces that act in parallel to the main surfaces of the process item, such that no relative movement takes place between process item and substrate during movement of the process item in parallel to the process media level.

In embodiments of the invention, the plate-shaped process item can be held on the support elements in the first operating mode exclusively by its weight force and a surface tension of the process medium, wherein no relative movement takes place between support elements and process item during movement of the process item in parallel to the process media level.

Thus, in embodiments of the present invention, slide elements engaging edges of the process item are not necessitated, since no relative movement between support elements and process item takes place due to the weight force of the process item and the surface tension of the process medium by which the process item is held on the support elements.

In embodiments of the invention, during the whole treatment with the process medium, the support elements of the transport means move together with the plate-shaped process item. Thus, during the treatment, a hand-over between different support elements or transport means is not compulsory, such that stress of the process item caused thereby can be reduced or prevented. A change of support elements can be provided to process the previous support areas. In embodiments of the invention, the support elements of the transport means move along a process path between take-over from a hand-over device and hand-over to a take-over device together with the plate-shaped process item. The hand-over device can thus be part of a previous treatment station, while the take-over device can be part of a subsequent treatment station. Thus, it becomes possible to transport the process item between treatment stations in an automated manner.

In embodiments, a change between support elements can take place during the process, i.e. during the treatment with the process medium, such that shading of the bottom side of the process item is reduced, and the whole bottom side of the process item can come into contact with the process medium during the treatment.

In embodiments of the invention, at least four support elements are provided for the plate-shaped process item to be treated, that are arranged spaced apart from one another, to support the plate-shaped process item to be treated at four points. This can allow secure support of the bottom side of the process item on the support elements, which supports the prevention of a relative movement between support elements and process item. In alternative embodiments, the transport means comprises only three support elements.

In embodiments of the invention, the support elements comprise support surfaces adapted as support for the plate-shaped process item to be treated, wherein the support elements comprise no parts projecting towards the top beyond these support surfaces. Thus, it can be ensured in embodiments of the invention that during movement in parallel to the process media level no parts of the support elements are engaged with edges of the process item or are arranged opposite to the edges of the process item within a specific distance.

In embodiments of the present invention, the endless means can further comprise a slide element projecting further from the same than the support elements. The slide element is spaced apart from the support elements such that, in the first operating mode, the same is not in mechanical contact with the edges of the plate-shaped process item or that the same is not arranged opposite to edges of the process item at a predetermined distance, wherein reference is made to the above statements regarding the predetermined distance. In embodiments of the invention, the apparatus and the method can be brought into a second operating mode by effecting a relative lowering of the support elements relative to the process media level, such that the normal force between support elements and plate-shaped process item is not sufficient to hold the plate-shaped process item on the support elements, such that a relative movement between support elements and plate-shaped process item takes place, by which the slide element comes in contact with an edge of the plate-shaped process item to allow transport of the plate-shaped process item by means of the slide element. In the second operating mode, the process item is immersed into the process medium, such that treatment of both the bottom side and the top side of the process item takes place. In embodiments, the relative lowering of the support elements relative to the process media level can be implemented by a respective adjustment of the height of the support elements. In alternative embodiments, the relative lowering can be effected by a respective raise of the process media level. Thus, embodiments of the invention allow switching between a first operating mode (one-sided treatment) and a second operating mode (two-sided treatment), such that the inventive apparatuses and methods can be used for both purposes by respective adjustment.

Embodiments of the present invention provide a method for producing a semiconductor wafer with an etched bottom side, by performing a respective inventive method, wherein the plate-shaped process item is the semiconductor wafer, and wherein the process medium is an etching means for etching at least the bottom side of the semiconductor disc. Thus, embodiments allow the production of a semiconductor disc having improved characteristics, since etching of the top side of the semiconductor disc can be securely prevented.

Embodiments of the present invention will be discussed below in more detail with reference to the accompanying drawings. They show:
- Fig. 1: a schematic side view for explaining an embodiment of the invention;
- Fig. 2a and 2: schematic top views for explaining transport means;
- Fig. 3: a schematic side view for explaining an embodiment of the invention;
- Fig. 4: a schematic bottom view of a processed process item;
- Fig. 5: a schematic side view for explaining an embodiment of the invention in a second operating mode;
- Fig. 6 and 7: schematic side views serving to explain the invention.

Before embodiments of the invention will be discussed in more detail with reference to the accompanying drawings, at first, some terms used in the application will be explained.

"Plate-shaped" body means a body whose length and width are significantly greater than its thickness, for example at least 100 or 200 times the size. Thereby, the length and width of the body define two main surfaces substantially opposing each other in parallel, which represent the largest areas of the plate-shaped body, whose area is significantly greater than the one of the side area(s) connecting the main surfaces. The side areas are herein referred to as edges, while the main surfaces are referred to as bottom side and top side. The number of edges depends on the shape of the body, wherein a square plate-shaped body comprises, for example, four edges.

The term "process media level" means the top horizontal area that is defined by the fill level of a process medium provided by a respective means, how the same would be if the same were not affected by gas bubbles or capillary effects or surface tension effects due to elements in the vicinity of the surface. In other words, herein, the process media level means the top surface of the process medium which would exist when the same were not affected by objects in the vicinity of the surface causing the generation of a meniscus.

The term "process medium" means any liquid suitable for treating the respective process item. The process medium can, for example, be any suitable etchant or any suitable cleaning agent, such as water.

In embodiments of the invention, the process item can be a plate-shaped substrate, in particular a plate-shaped semiconductor substrate, such as a plate-shaped silicon wafer as used in the production of solar cells. In alternative embodiments, the process item can be another plate-shaped body, for example a glass plate or a polymer plate. All bodies having such a density with respect to the process medium that the described effect of holding the process item on the support elements can appear can be considered as process item. In embodiments of the invention, the process item can comprise a monocrystalline semiconductor wafer (for example silicon wafer) surrounded by a doped layer (for example phosphor-doped layer) that is again surrounded by a glass layer (for example phosphor glass layer). Such wafers are known to a person skilled in the art. Embodiments of the invention can be adapted to remove the glass layer and the doped layer from the bottom side of the substrate by means of etching, which will be referred to as emitter etching. Respective etchants that can be used as process medium for that are sufficiently known to persons skilled in the art. Embodiments of the invention can be adapted to perform, after such bottom side etching, polishing etching of the bottom side in order to make the same as smooth as glass for reducing reflections during later usage and to thereby increase the efficiency. Due to the one-sided treatment, in embodiments of the invention, the edges of a respective substrate can be etched simultaneously when the process medium wets the edges due to the surface tension.

A "support element" means an element on which the bottom side of the plate-shaped process item is supported, wherein no part of the support element projects towards the top beyond the bottom side of the plate-shaped process item. Thus, the area of the support elements on which the bottom side of the plate-shaped process item is supported presents the highest point of the support element.

The directions "top" and "bottom" are defined herein by the process media level which is substantially horizontal.

Herein, one-sided processing means processing where one main surface of the body but not the other main surface of the same is treated, wherein the edges may be treated or not. Two-sided processing means processing where both main surfaces of the body are treated (and normally also the edges of the same).

Embodiments of the invention generally relate to the transport of plate-shaped substrates, wherein embodiments of apparatuses and methods are in particular suitable for transport and treatment of silicon discs, where only one partial area of the surface is to be modified. For a person skilled in the art, it is obvious that the inventive methods and apparatuses can be adapted for respective plate-shaped process items of different sizes. Embodiments of the invention allow that during one-sided etching processes which are to modify only one side as well as the edges of wafers, damaging of the surface that is not to be treated by process media reaching the surface unintentionally can be prevented. Further, embodiments of the invention allow, apart from such a first operating mode representing one-sided processing an adaptation for a second operating mode in which two-sided processing takes place. The respective methods and apparatuses can be adapted for the respective purpose.

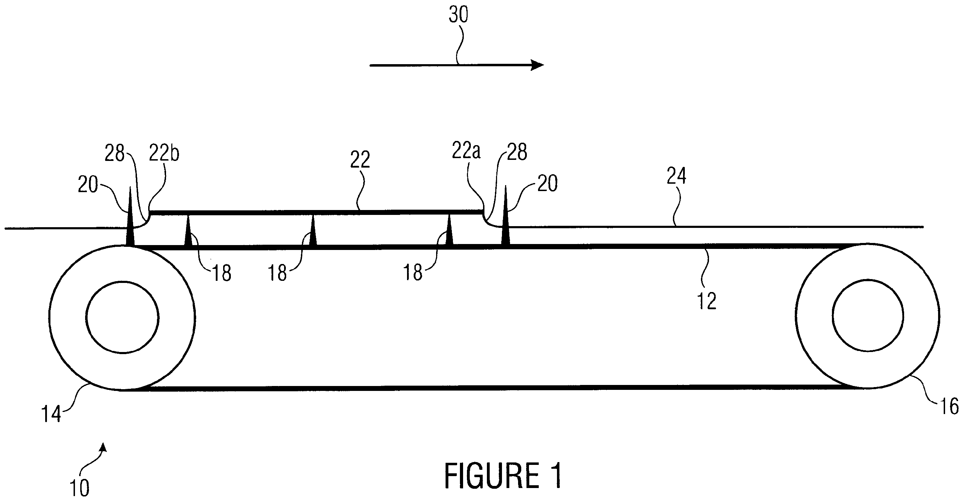

Fig. 1 shows a schematic side view for explaining the invention. A transport means 10 comprises an endless means 12 running around rollers 14 and 16, wherein one of the rollers 12, 14 can be a driving roller. The endless means 12 can be formed, for example, by one or several chains or one or several belts as known to a person skilled in the art. The transport means 10 comprises support elements 18 projecting from an external side of the endless means 12 facing away from the rollers 14 and 16.

In the embodiment shown in Fig. 1, the transport means 10 further comprises slide elements 20 projecting in the same direction from the endless means 12 as the support elements. The slide elements 20 are optional and project further from the endless means 12 than the support elements 18. A plate-shaped process item 22 in the form of a semiconductor wafer is supported on the support elements 18. Fig. 1 further illustrates a process media level 24 of a process medium by which the bottom side of the semiconductor wafer 22 is to be treated. When the support elements 18 support the semiconductor wafer 22 the same project towards the top from the endless means 12.

A transport direction is illustrated in Fig. 1 by arrow 30, wherein a front of the semiconductor wafer in the direction of movement is indicated with reference number 22a in Fig. 1, and a rear edge in the direction of movement is indicated by reference number 22b. As can be see in Fig. 1, the height of the support elements 18 is adjusted relative to the process media level 24 such that menisci 28 are formed at the edges of the semiconductor wafer 22, such that the bottom side of the semiconductor wafer 22 is completely wetted with the process medium (with the exception of the positions where the bottom side of the semiconductor wafer 22 is supported on the support elements 18). In other words, the level of the process medium below the semiconductor wafer 22 is above the process media level 24. A suitable means for providing the process medium, such that the process media level 24 is obtained, is provided, but not shown in Fig. 1.

The transport means 10 and the means for providing the process medium are implemented to adjust the height of the support elements 18 relative to the process media level such that the above described effect is obtained. Thereby, the semiconductor wafer 22 is held on the support elements 18 by its force of weight and by the surface tension of the process medium. As can be seen in Fig. 1, the transport means is implemented to move the support elements 18 with the semiconductor wafer 20 supported thereon horizontally across the process media level 24, wherein during this movement the menisci 28 remain, such that the bottom side of the semiconductor wafer 22 remains wetted with the process medium. During this horizontal movement (i.e. in parallel to the process media level), no relative movement between support elements 18 and semiconductor wafer 22 takes place, since the same is held on the support elements by the above-described effects.

As can be seen in Fig. 1, during this movement, no parts of the transport means engage the edges 22a and 22b of the semiconductor wafer 22. Thus, unintentional creeping of the process medium onto the top side of the semiconductor wafer 22 can be effectively reduced or prevented.

As can further be seen in Fig. 1, the optional slide elements 20 are provided at a sufficient distance from the edges 22a and 22b of the semiconductor wafer 22 to prevent wicking caused by capillary forces. Normally, a distance of at least 5 mm should be sufficient to prevent this. Generally, at a distance that is smaller than a contact radius of the process medium due to the surface tension of the same, no parts of the transport means should be arranged opposite to the edges of the process item. As known to persons skilled in the art, this contact radius depends on the process medium as well as the material that the same contacts.

In embodiments of the invention, the means for providing the process medium and the transport means are implemented such that no parts of the transport means are arranged at a specific distance in the direction of movement in front of and behind the process item. In embodiments of the invention, the means for providing the process medium and the transport means are implemented such that even at a respective distance laterally (transversely to the direction of movement) from the process item, no parts of the transport means or the means for providing the process medium are arranged.

During operation, the semiconductor wafer 22 is placed on the support elements 18 which are arranged only below the same. Subsequently, the transport means is driven to move the support elements 18 together with the semiconductor wafer 22 in the direction of arrow 30. During this movement in parallel to the process media level 24, edges 22a and 22b of the semiconductor wafer 22 are not engaged with parts of the transport means. Thereby, while forming and maintaining the meniscus 28 between the semiconductor wafer 22 and the surface of a liquid bath, the semiconductor is partly wetted with the process medium within the bath and transported horizontally across the bath, wherein the top side of the substrate not to be treated is always positioned above the gauge height of the liquid, and the level of liquid contacted by the substrate is maintained above the gauge height of the bath surface not contacted by the substrate.

Due to the contact between the support elements 18 and the semiconductor wafer 22, only partial processing can take place on the bottom side of the same. To keep the unprocessed areas on the semiconductor wafer as small as possible, the support areas should be as small as possible. In embodiments of the invention, where emitter etching or polishing etching of a solar cell semiconductor wafer is performed, effects on the functionality of the produced semiconductor wafer caused by the untreated parts on the bottom side of the wafer can be neglected.

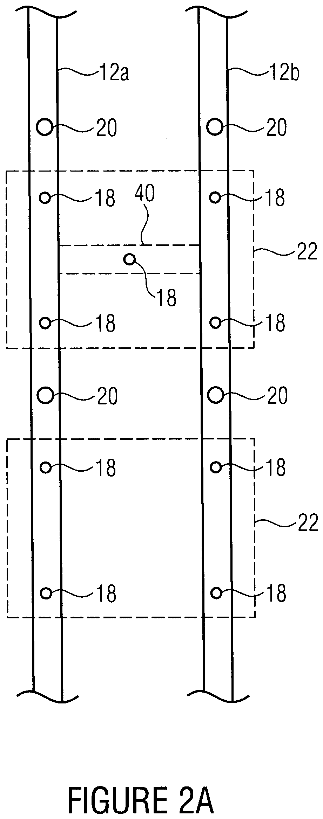

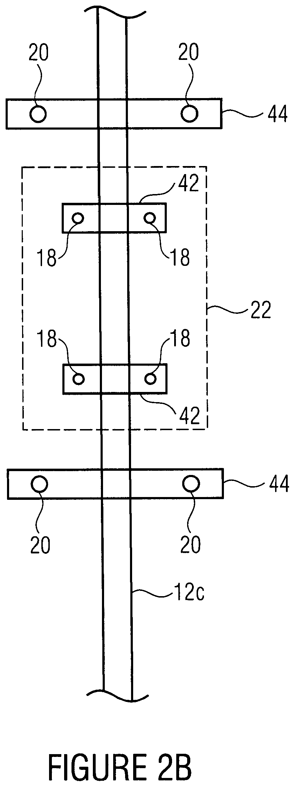

A schematic top view of embodiments of an endless means with projecting support elements and slide elements is shown in Figs. 2a and 2b to illustrate the arrangement of support elements and slide elements. Fig. 2a shows an endless means having two parallel chains 12a and 12b on which support elements 18 and slide elements 20 are provided. As can be seen in the embodiment shown in Fig. 2a, the semiconductor wafer 22 is supported on four support elements. In alternative embodiments, a connecting ridge 40 could be provided between chains 12a and 12b, on which a further support element 18 can be arranged, which is arranged substantially centrally relative to the wafer 22. As obvious to a person skilled in the art and as indicated in Fig. 2a, several groups of support elements can be provided on the endless means, such that several wafers 22 can be transported and treated successively.

An alternative embodiment of an endless means having only one chain 12c is shown in Fig. 2b. Lateral ridges 42 from which the support elements 18 project are arranged on the chain 12c. Further, lateral ridges 44 from which optional slide elements 20 project are mounted on the chain 12c. Again, Fig. 2b only schematically shows one wafer 22 supported on four support elements 18. Again, optionally, a further support element could be provided that is arranged centrally between the four shown support elements 18 on the chain 12c.

In embodiments of the invention, the endless means, for example one or several chains or one or several belts can be formed of any suitable material, for example plastic, metal, steel or titanium. It is obvious to a person skilled in the art that the shown arrangement and number of support elements only serve illustrating purposes and that other arrangements or numbers of support elements can be used. Normally, however, four or five support elements, as described, will provide sufficient support of the wafer to prevent relative movement between wafer and support elements during movement in parallel to the process media level.

For example, as can be seen in Fig. 1, three support elements 18 can be provided in two rows behind one another, such that all in all six support elements are provided. In alternative embodiments, elongated support elements whose longer dimensions extend in transport direction, can be provided spaced apart from one another laterally to the transport direction, wherein in such a case two support elements can be sufficient.

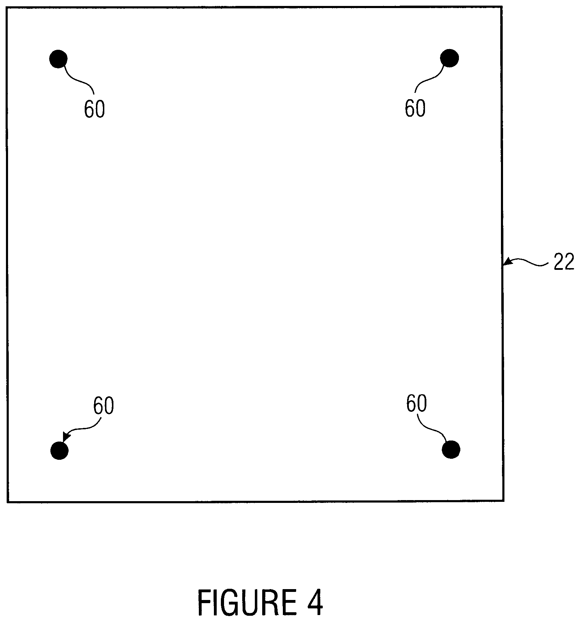

Fig. 4 shows schematically the bottom side of an embodiment of a semiconductor wafer produced by means of an inventive method, for example a silicon wafer. As shown in Fig. 4, four points 60 can be seen on the bottom side, where the semiconductor wafer 22 had been supported during the treatment on support elements, such that no treatment of the surface has taken place there. For keeping these points 60 as small as possible, the support elements can be, for example, circular with a diameter of less than 5 mm or less than 1 mm. Generally, the support elements can have any form, for example rectangular, square, oval or the same, wherein a largest dimension of the support area of the support elements in any direction can be smaller than 5mm or smaller than 1 mm. For example, the support area can be less than 25 mm² or less than 1 mm².

Generally, the support elements can be arranged such that a distance which can be more than 10 mm or more than 20 mm, exists between the edges of the process item and the support areas of the support elements,.

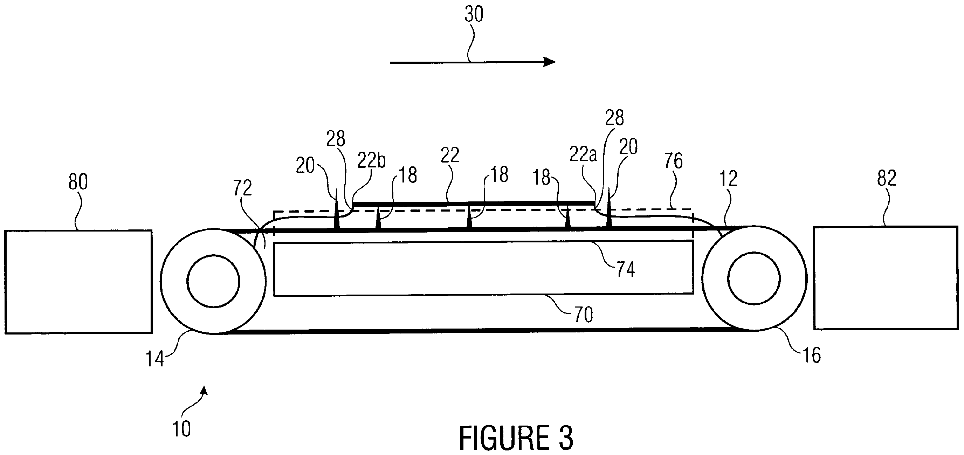

Fig. 3 shows schematically a side view of the embodiment shown in Fig. 1, wherein the semiconductor wafer 22 has been moved further in the transport direction 30 by the transport means 10. Fig. 3 further shows a means 70 for providing the process medium 72. The means 70 can be formed, for example, by an overflow basin, by which a liquid supernatant of the process medium beyond a top edge 74 of the basin can be effected.

Lateral limitations to prevent lateral draining of the liquid supernatant are illustrated in Fig. 32 in a dotted manner and indicated by reference number 76. At the front and rear ends in transport direction, also, limitations can be provided that reduce draining of the liquid supernatant, wherein these limitations comprise openings to allow passage of the endless means 12, the support elements 18, the slide elements 20 as well as the transported process item. For a person skilled in the art, it is obvious that other means for providing a process medium can be provided. With respect to means for providing a process medium, reference is made to WO 2010/009865 A1, the teaching of which is incorporated herein by reference.

Further, Fig. 3 schematically shows a handover apparatus 80 and a takeover apparatus 82. The handover apparatus 80 is implemented to hand over the process item to the transport means 10, and the takeover apparatus 82 is implemented to take over the process item from the transport means 10. Regarding possible implementations of the handover apparatus 80 and the takeover apparatus 82, again, reference is made to the teaching of WO 2010/009865 A1, whose teaching concerning this is incorporated herein by reference.

As can be seen from the above description, the slide elements 20 are not necessitated for transporting the plate-shaped process item in the described first operating mode. However, in this first operating mode, the slide elements 20 can be advantageous, for example to remove broken semiconductor wafer parts from the plant. For transporting the semiconductor wafer 22 during the whole treatment with the process medium, the slide elements 20 are not necessitated, since the process item is held on the support elements 18 by its weight force and the surface tension of the process media during the whole movement during which the process item is in contact with the process medium which is parallel to the process media level. The movement can also proceed, at first, in a tilted or arch-shaped manner towards the process medium, then parallel to the process medium level and then in a transversal or arch-shaped manner away from the process medium.

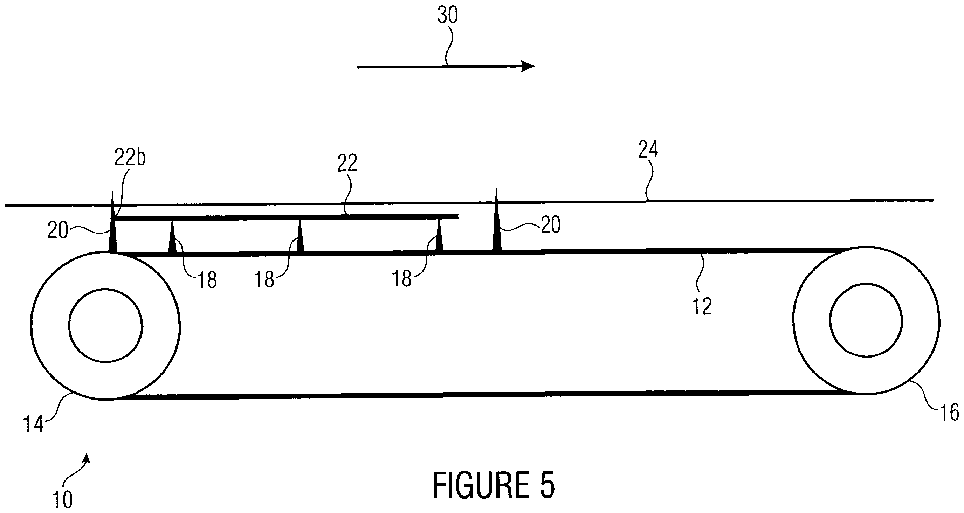

However, the slide elements 20 allow adaptation of the plant for a second operating mode, where two-sided treatment of a process item takes place. A schematic side view showing this second operating mode is illustrated in Fig. 5. In this second operating mode, the support elements 18 are lowered with respect to the process media level 24 such that the process item (for example the semiconductor wafer) 22 is partly or completely immersed in the process medium. Here, the semiconductor wafer 22 has a higher density than the process medium, such that same is supported on the support elements 18. However, this weight force (normal force between the process item 22 and the support elements 18) is no longer sufficient to prevent relative movement, such that the same takes place. The relative movement is stopped by the contact of the edge 22b of the semiconductor wafer 22 towards the back in the direction of movement with the slide element 20 at the back in the direction of movement. In the second operating mode, where two-sided treatment of the process item takes place, the transport of the process item thus takes place in the direction of movement by the tight fit between the slide element 20 and the back edge 22 of the process item 22. Thus, two-sided processing of the process item 22 is possible without using downholders, whereby negative effects on the top side of the process item can be prevented.

Thus, embodiments of the present invention can be adapted for two different operating modes. Lowering the support elements 18 in relation to the process media level 24 can be effected by respective mechanical positioning of the transport means 10 in relation to the means for providing a process medium. Means allowing respective positioning, for example servo motors and allocated controls can be provided.

Thus, embodiments of the invention allow an adaptation either for one-sided processing (for example bottom side etching of a semiconductor wafer) or two-sided processing (for example cleaning an etched semiconductor wafer). Embodiments of the invention prevent both relative movements between process item and transport means and splitting effects between process item and slide elements during one-sided processing in the first operating mode. In the case of two-sided processing, embodiments of the invention require no downholder.

For exhausting process vapors, a suction channel can be provided in embodiments of the invention. The suction channel can be attached below the endless means and can comprise entry openings just above the process media level 24.

In embodiments, one or several further exit openings can be provided for media drain transversely to the transport direction. Further, seen in transport direction, exit openings can be provided for example, at the entry/exit into /from the basin. Such exit openings allow, among others, removal of gas bubbles presenting a reaction product in a shorter way than with conventional overflow weirs at the entry/exit into/from the basin. Further, by such exit openings, a high media exchange rate below the wafer can be obtained.

In embodiments of the invention, as shown in Fig. 3, merely parts of the endless means 12 as well as at least parts of the support elements 18 and the slide elements 20 are within the process medium 72. Thus, contaminations of the process medium by debris can be prevented. In alternative embodiments, the rollers 14 and 16 can also be within a liquid bath in which the process medium is provided.

No further explanation is necessitated that further support elements or slide elements for the transport of further process items, for example semiconductor wafers, can be provided on the respective endless means. For example, support elements and slide elements can be provided at regular intervals across the whole length of the endless means.

The slide elements 20 can support takeover of the process item from a handover apparatus 80 or handover of the process item to a takeover apparatus 82. For example, the slide element at the back in a direction of movement can slide the process item 22 onto the support elements 18 during takeover and slide it off the support elements 18 during handover. During movement in parallel to the process media level, however, the process item 22 will be positioned centrally between the slide elements 20 due to surface tensions and capillary forces effecting the menisci 28, so that no contact between the edges of the process item and the slide elements takes place.

Thus, in embodiments of the invention, the spacing between two slide elements 20 is set such that during transport of the process item in the first operating mode, respective spacings exist between front and back edge of the process item and the slide elements.

Thus, embodiments of the present invention provide apparatuses and methods for transporting plate-shaped substrates during one-sided wet-chemical treatment (for example processing the bottom side or bottom side and edges) by using a liquid bath, where the substrates are supported on at least one endless means, such that relative movement between transport elements and substrate is prevented and no contact to the circumferential surface (i.e. edge) of the substrate exists. In embodiments, the apparatus or the method can be adapted such that during processing the top and bottom side (two-sided processing) as well as the edges, a tight-fit transport results due to contact of the circumferential surface (edge) with at least one slide element.

Finally, it should be noted that in embodiments of the invention, the edges of the process item are also treated during the one-sided treatment, due to the meniscus that is formed at the edges of the process item.

## Claims

1. An apparatus for treating a plate-shaped process item (22) comprising a bottom side, a top side and edges (22a, 22b) between the bottom side and the top side, with a process medium (72), comprising:
a means (70) for providing a process medium (72) with a process media level (24);
a transport means (10) comprising an endless means (12) with support elements (18) projecting from the same, on which a bottom side of the plate-shaped process item (22) to be treated can be supported, wherein the transport means (10) is implemented to move the support elements (18) together with the supported plate-shaped process item (22) in parallel to the process media level (24) of the process medium (72),
wherein the means (70) for providing the process medium (72) and the transport means (10) are adapted for a plate-shaped process item (22) to be treated such that during movement of the plate-shaped process item (22) in parallel to the process media level (24) of the process medium (72), at least those parts of the bottom side of the plate-shaped process item (22) that are not supported on the support elements (18) are in contact with the process medium (72),
**characterized in that** the transport means (10) is implemented such that in a first operating mode, during movement of the plate-shaped process item (22) in parallel to the process media level (24), no parts of the transport means (10) engage the edges (22a, 22b) of the plate-shaped process item (22), wherein the first operating mode corresponds to a one side processing treatment of the bottom side of the plate-shaped process item, in which the edges of the plate-shaped process item may be treated or not.

2. The apparatus according to claim 1, wherein the means (70) for providing the process medium (72) and the transport means (10) are adapted for the plate-shaped process item (22) to be treated such that the support elements (18) on which the process item (22) is supported project from the process media level (24) during the first operating mode, such that during movement of the plate-shaped process item (22) in parallel to the process media level (24) a meniscus (28) is formed between the plate-shaped process item (22) and the process medium (72), such that the gauge height of the process medium (72) that is in contact with the bottom side of the plate-shaped process item (22) is above the process media level (24).

3. The apparatus according to claim 2, wherein the means (70) for providing the process medium (72) and the transport means (10) are adapted for the plate-shaped process item (22) to be treated such that, in the first operating mode, the plate-shaped process item (22) is held on the support elements (18) merely by its weight force and surface tension of the process medium (72), such that relative movement between the support elements (18) and the process item (22) is prevented.

4. The apparatus according to one of claims 1 to 3, wherein the support elements (18) of the transport means (10) are implemented to move together with the plate-shaped process item (22) during the whole treatment with the process medium (72).

5. The apparatus according to claim 4, wherein the support elements (18) of the transport means (10) are implemented to move along a process path between takeover from a handover apparatus (80) and handover to a takeover apparatus (82) together with the plate-shaped process item (22).

6. The apparatus according to one of claims 1 to 5, wherein the transport means (10) comprises at least four support elements (18) for the plate-shaped process item (22) to be treated, which are spaced apart from one another, to support the plate-shaped process item (22) to be treated at at least four points.

7. The apparatus according to one of claims 1 to 6, wherein the means (70) for providing the process medium (72) and the transport means (10) are adapted to the plate-shaped process item (22) to be treated such that, in the first operating mode, during movement of the plate-shaped process item (22) in parallel to the process media level (24), no parts of the transport means (10) are arranged opposite to the edges (22a, 22b) of the plate-shaped process item (22) at a distance that is smaller than a contact radius of the process medium (72) due to the surface tension of the same.

8. The apparatus according to one of claims 1 to 7, wherein the means (70) for providing the process medium (72) and the transport means (10) are adapted to the plate-shaped process item (22) to be treated such that in the first operating mode, during movement of the plate-shaped process item (22) in parallel to the process media level (24), no parts of the transport means (10) are arranged opposite to the edges (22a, 22b) of the plate-shaped process item (22) at a distance that is smaller than 5 mm.

9. The apparatus according to one of claims 1 to 8, wherein the endless means (12) further comprises a slide element (20) that projects further from the same than the support elements (18), wherein the slide element (20) is spaced apart from the support elements (18) such that the same is not in mechanical contact with the edges (22a, 22b) of the plate-shaped process item (22) in the first operating mode, wherein the apparatus further comprises a means for effecting relative lowering of the support elements (18) relative to the process media level (24), such that, in a second operating mode, the normal force between support elements (18) and plate-shaped process item (22) is not sufficient to hold the plate-shaped process item (22) on the support elements (18), such that relative movement between the support elements (18) and the plate-shaped process item (22) takes place, by which the slide element (20) comes in contact with an edge of the plate-shaped process item (22) to allow transport of the plate-shaped process item (22) by means of the slide element (20).

10. The apparatus according to one of claims 1 to 9, wherein the support elements (18) comprise support surfaces adapted as support for the plate-shaped process item (22) to be treated, wherein the support elements (18) comprise no parts projecting beyond these support surfaces towards the top.

11. A method for treating a plate-shaped process item (22) comprising a bottom side, a top side and edges (22a, 22b) between the bottom side and the top side, with a process medium (72) by using a transport means (10) comprising an endless means (12) with support elements (18) projecting from the same, comprising:
supporting a bottom side of the plate-shaped process item (22) on support elements (18) of the transport means (10); and
driving the transport means (10) to move the support elements (18) together with the supported plate-shaped process item (22) in parallel to a process media level (24) of a process medium (72), wherein at least those parts of the bottom side of the plate-shaped process item (22) that are not supported on support elements (18) are in contact with the process medium (72),
**characterized in that**, in a first operating mode during movement of the plate-shaped process item (22) in parallel to the process media level (24), no parts of the transport means (10) engage the edges (22a, 22b) of the plate-shaped process item (22), wherein the first operating mode corresponds to a one side processing treatment of the bottom side of the plate-shaped process item, in which the edges of the plate-shaped process item may be treated or not.

12. The method according to claim 11, wherein the support elements (18) on which the process item (22) are supported project, in the first operating mode, from the process media level (24) such that during movement of the plate-shaped process item (22) in parallel to the process media level (24) a meniscus (28) is formed between the plate-shaped process item (22) and the process medium (72), such that the gauge height of the process medium (72) that is in contact with the bottom side of the plate-shaped process item (22) is above the process media level (24).

13. The method according to claim 12, wherein, in the first operating mode, the plate-shaped process item (22) is held on the support elements (18) merely by its weight force and surface tension of the process medium (72), such that relative movement between support elements (18) and process item (22) is prevented.

14. The method according to one of claims 1 to 13, wherein the support elements (18) of the transport means (10) are moved together with the plate-shaped process item (22) during the whole treatment with the process medium (72).

15. The method according to claim 14, wherein the support elements (18) of the transport means (10) are moved along a process path between takeover from a handover apparatus (80) and handover to a takeover apparatus (82) together with the plate-shaped process item (22).

16. The method according to one of claims 11 to 15, wherein the plate-shaped process item (22) is supported on at least four support elements (18), that are spaced apart from one another, to support the plate-shaped process item (22) to be treated at at least four points.

17. The method according to one of claims 11 to 16, wherein, in the first operating mode, no parts of the transport means (10) are arranged opposite to the edges (22a, 22b) of the plate-shaped process item (22) at a distance that is smaller than a contact radius of the process medium (72) due to the surface tension of the same.

18. The method according to one of claims 11 to 17, wherein, in the first operating mode, no parts of the transport means (10) are arranged opposite to the edges (22a, 22b) of the plate-shaped process item (22) at a distance that is smaller than 5 mm.

19. The method according to one of claims 11 to 18, wherein a slide element (20) projects further from the endless means (12) than the support elements (18), wherein the slide element (20) is spaced apart from the support elements (18) such that the same is not in mechanical contact with the edges (22a, 22b) of the plate-shaped process item (22) in the first operating mode, wherein, in a second operating mode, for treating the bottom side and the top side of the plate-shaped process item (22), relative lowering of the support elements (18) relative to the process media level (24) can be effected, such that the normal force between support elements (18) and plate-shaped process item (22) is not sufficient to hold the plate-shaped process item (22) on the support elements (18), such that relative movement between the support elements (18) and the plate-shaped process item (22) takes place, by which the slide element (20) comes in contact with an edge of the plate-shaped process item (22) to allow transport of the plate-shaped process item (22) by means of the slide element (20).

20. A method for producing a semiconductor wafer with an etched bottom side, comprising:
performing a method according to one of claims 11 to 18, wherein the plate-shaped process item (22) is the semiconductor wafer, and wherein the process medium (72) is an etchant for etching at least the bottom side of the semiconductor wafer.

## Patentansprüche

1. Eine Vorrichtung zum Behandeln eines plattenförmigen Verarbeitungsgegenstands (22), der eine Unterseite, eine Oberseite und Kanten (22a, 22b) zwischen der Unterseite und der Oberseite aufweist, mit einem Verarbeitungsmedium (72), wobei die Vorrichtung folgende Merkmale aufweist:
eine Einrichtung (70) zum Bereitstellen eines Verarbeitungsmediums (72) mit einer Verarbeitungsmedienebene (24);
eine Transporteinrichtung (10), die eine Endloseinrichtung (12) mit von derselben hervorstehenden Trageelementen (18) aufweist, auf denen eine Unterseite des zu behandelnden plattenförmigen Verarbeitungsgegenstands (22) getragen werden kann, wobei die Transporteinrichtung (10) dahin gehend implementiert ist, die Trageelemente (18) zusammen mit dem getragenen plattenförmigen Verarbeitungsgegenstand (22) parallel zu der Verarbeitungsmedienebene (24) des Verarbeitungsmediums (72) zu bewegen,
wobei die Einrichtung (70) zum Bereitstellen des Verarbeitungsmediums (72) und die Transporteinrichtung (10) derart für einen zu behandelnden plattenförmigen Verarbeitungsgegenstand (22) angepasst sind, dass während einer Bewegung des plattenförmigen Verarbeitungsgegenstands (22) parallel zu der Verarbeitungsmedienebene (24) des Verarbeitungsmediums (72) zumindest diejenigen Teile der Unterseite des plattenförmigen Verarbeitungsgegenstands (22), die nicht auf den Trageelementen (18) getragen werden, in Kontakt mit dem Verarbeitungsmedium (72) sind,
**dadurch gekennzeichnet, dass** die Transporteinrichtung (10) derart implementiert ist, dass in einem ersten Betriebsmodus während einer Bewegung des plattenförmigen Verarbeitungsgegenstands (22) parallel zu der Verarbeitungsmedienebene (24) keine Teile der Transporteinrichtung (10) die Kanten (22a, 22b) des plattenförmigen Verarbeitungsgegenstands (22) in Eingriff nehmen, wobei der erste Betriebsmodus einer einseitigen Verarbeitungsbehandlung der Unterseite des plattenförmigen Verarbeitungsgegenstands entspricht, bei der die Kanten des plattenförmigen Verarbeitungsgegenstands behandelt werden können oder nicht.

2. Die Vorrichtung gemäß Anspruch 1, bei der die Einrichtung (70) zum Bereitstellen des Verarbeitungsmediums (72) und die Transporteinrichtung (10) derart für einen zu behandelnden plattenförmigen Verarbeitungsgegenstand (22) angepasst sind, dass die Trageelemente (18), auf denen der Verarbeitungsgegenstand (22) getragen wird, während des ersten Betriebsmodus von der Verarbeitungsmedienebene (24) hervorstehen, so dass während einer Bewegung des plattenförmigen Verarbeitungsgegenstands (22) parallel zu der Verarbeitungsmedienebene (24) zwischen dem plattenförmigen Verarbeitungsgegenstand (22) und dem Verarbeitungsmedium (72) ein Meniskus (28) gebildet wird, so dass die Messhöhe des Verarbeitungsmediums (72), das in Kontakt mit der Unterseite des plattenförmigen Verarbeitungsgegenstands (22) ist, über der Verarbeitungsmedienebene (24) ist.

3. Die Vorrichtung gemäß Anspruch 2, bei der die Einrichtung (70) zum Bereitstellen des Verarbeitungsmediums (72) und die Transporteinrichtung (10) derart für einen zu behandelnden plattenförmigen Verarbeitungsgegenstand (22) angepasst sind, dass der plattenförmige Verarbeitungsgegenstand (22) in dem ersten Betriebsmodus lediglich durch eine Gewichtskraft desselben und eine Oberflächenspannung des Verarbeitungsmediums (72) auf den Trageelementen (18) gehalten wird, so dass eine relative Bewegung zwischen den Trageelementen (18) und dem Verarbeitungsgegenstand (22) verhindert wird.

4. Die Vorrichtung gemäß einem der Ansprüche 1 bis 3, bei der die Trageelemente (18) der Transporteinrichtung (10) dahin gehend implementiert sind, sich während der gesamten Behandlung mit dem Verarbeitungsmedium (72) zusammen mit dem plattenförmigen Verarbeitungsgegenstand (22) zu bewegen.

5. Die Vorrichtung gemäß Anspruch 4, bei der die Trageelemente (18) der Transporteinrichtung (10) dahin gehend implementiert sind, sich zwischen Übernahme von einer Übergabevorrichtung (80) und Übergabe an eine Übernahmevorrichtung (82) zusammen mit dem plattenförmigen Verarbeitungsgegenstand (22) entlang eines Verarbeitungswegs zu bewegen.

6. Die Vorrichtung gemäß einem der Ansprüche 1 bis 5, bei der die Transporteinrichtung (10) zumindest vier Trageelemente (18) für den zu behandelnden plattenförmigen Verarbeitungsgegenstand (22) aufweist, die voneinander beabstandet sind, um den zu behandelnden plattenförmigen Verarbeitungsgegenstand (22) an zumindest vier Punkten zu tragen.

7. Die Vorrichtung gemäß einem der Ansprüche 1 bis 6, bei der die Einrichtung (70) zum Bereitstellen des Verarbeitungsmediums (72) und die Transporteinrichtung (10) derart an den zu behandelnden plattenförmigen Verarbeitungsgegenstand (22) angepasst sind, dass in dem ersten Betriebsmodus während einer Bewegung des plattenförmigen Verarbeitungsgegenstands (22) parallel zu der Verarbeitungsmedienebene (24) keine Teile der Transporteinrichtung (10) gegenüber den Kanten (22a, 22b) des plattenförmigen Verarbeitungsgegenstands (22) in einem Abstand angeordnet sind, der kleiner ist als ein Kontaktradius des Verarbeitungsmediums (72) aufgrund der Oberflächenspannung desselben.

8. Die Vorrichtung gemäß einem der Ansprüche 1 bis 7, bei der die Einrichtung (70) zum Bereitstellen des Verarbeitungsmediums (72) und die Transporteinrichtung (10) derart an den zu behandelnden plattenförmigen Verarbeitungsgegenstand (22) angepasst sind, dass in dem ersten Betriebsmodus während einer Bewegung des plattenförmigen Verarbeitungsgegenstands (22) parallel zu der Verarbeitungsmedienebene (24) keine Teile der Transporteinrichtung (10) gegenüber den Kanten (22a, 22b) des plattenförmigen Verarbeitungsgegenstands (22) in einem Abstand angeordnet sind, der kleiner ist als 5 mm.

9. Die Vorrichtung gemäß einem der Ansprüche 1 bis 8, bei der die Endloseinrichtung (12) ferner ein Schiebeelement (20) aufweist, das weiter von derselben hervorsteht als die Trageelemente (18), wobei das Schiebeelement (20) derart von den Trageelementen (18) beabstandet ist, dass dasselbe in dem ersten Betriebsmodus nicht in mechanischem Kontakt mit den Kanten (22a, 22b) des plattenförmigen Verarbeitungsgegenstands (22) ist, wobei die Vorrichtung ferner eine Einrichtung zum Ausführen eines relativen Senkens der Trageelemente (18) relativ zu der Verarbeitungsmedienebene (24) aufweist, so dass in einem zweiten Betriebsmodus die Normalkraft zwischen Trageelementen (18) und plattenförmigem Verarbeitungsgegenstand (22) nicht ausreichend ist, um den plattenförmigen Verarbeitungsgegenstand (22) auf den Trageelementen (18) zu halten, so dass eine relative Bewegung zwischen den Trageelementen (18) und dem plattenförmigen Verarbeitungsgegenstand (22) stattfindet, durch die das Schiebeelement (20) dahin gehend mit einer Kante des plattenförmigen Verarbeitungsgegenstands (22) in Kontakt kommt, einen Transport des plattenförmigen Verarbeitungsgegenstands (22) mittels des Schiebeelements (20) zu ermöglichen.

10. Die Vorrichtung gemäß einem der Ansprüche 1 bis 9, bei der die Trageelemente (18) Trageoberflächen aufweisen, die als Stütze für den zu behandelnden plattenförmigen Verarbeitungsgegenstand (22) angepasst sind, wobei die Trageelemente (18) keine Teile aufweisen, die über diese Trageoberflächen hinaus nach oben hin hervorstehen.

11. Ein Verfahren zum Behandeln eines plattenförmigen Verarbeitungsgegenstands (22), der eine Unterseite, eine Oberseite und Kanten (22a, 22b) zwischen der Unterseite und der Oberseite aufweist, mit einem Verarbeitungsmedium (72) unter Verwendung einer Transporteinrichtung (10), die eine Endloseinrichtung (12) mit Trageelementen (18) aufweist, die von derselben hervorstehen, wobei das Verfahren folgende Schritte aufweist:
Tragen einer Unterseite des plattenförmigen Verarbeitungsgegenstands (22) auf Trageelementen (18) der Transporteinrichtung (10); und
Antreiben der Transporteinrichtung (10) dahin gehend, die Trageelemente (18) zusammen mit dem getragenen plattenförmigen Verarbeitungsgegenstand (22) parallel zu einer Verarbeitungsmedienebene (24) eines Verarbeitungsmediums (72) zu bewegen, wobei zumindest diejenigen Teile der Unterseite des plattenförmigen Verarbeitungsgegenstands (22), die nicht auf Trageelementen (18) getragen werden, in Kontakt mit dem Verarbeitungsmedium (72) sind,
**dadurch gekennzeichnet, dass** in einem ersten Betriebsmodus während einer Bewegung des plattenförmigen Verarbeitungsgegenstands (22) parallel zu der Verarbeitungsmedienebene (24) keine Teile der Transporteinrichtung (10) die Kanten (22a, 22b) des plattenförmigen Verarbeitungsgegenstands (22) in Eingriff nehmen, wobei der erste Betriebsmodus einer einseitigen Verarbeitungsbehandlung der Unterseite des plattenförmigen Verarbeitungsgegenstands entspricht, bei der die Kanten des plattenförmigen Verarbeitungsgegenstands behandelt werden können oder nicht.

12. Das Verfahren gemäß Anspruch 11, bei dem die Trageelemente (18), auf denen der Verarbeitungsgegenstand (22) getragen wird, in dem ersten Betriebsmodus derart von der Verarbeitungsmedienebene (24) hervorstehen, dass während einer Bewegung des plattenförmigen Verarbeitungsgegenstands (22) parallel zu der Verarbeitungsmedienebene (24) zwischen dem plattenförmigen Verarbeitungsgegenstand (22) und dem Verarbeitungsmedium (72) ein Meniskus (28) gebildet wird, so dass die Messhöhe des Verarbeitungsmediums (72), das in Kontakt mit der Unterseite des plattenförmigen Verarbeitungsgegenstands (22) ist, über der Verarbeitungsmedienebene (24) ist.

13. Das Verfahren gemäß Anspruch 12, bei dem der plattenförmige Verarbeitungsgegenstand (22) in dem ersten Betriebsmodus lediglich durch eine Gewichtskraft desselben und eine Oberflächenspannung des Verarbeitungsmediums (72) auf den Trageelementen (18) gehalten wird, so dass eine relative Bewegung zwischen den Trageelementen (18) und dem Verarbeitungsgegenstand (22) verhindert wird.

14. Das Verfahren gemäß einem der Ansprüche 1 bis 13, bei dem die Trageelemente (18) der Transporteinrichtung (10) während der gesamten Behandlung mit dem Verarbeitungsmedium (72) zusammen mit dem plattenförmigen Verarbeitungsgegenstand (22) bewegt werden.

15. Das Verfahren gemäß Anspruch 14, bei dem die Trageelemente (18) der Transporteinrichtung (10) zwischen Übernahme von einer Übergabevorrichtung (80) und Übergabe an eine Übernahmevorrichtung (82) zusammen mit dem plattenförmigen Verarbeitungsgegenstand (22) entlang eines Verarbeitungswegs bewegt werden.

16. Das Verfahren gemäß einem der Ansprüche 11 bis 15, bei dem der plattenförmige Verarbeitungsgegenstand (22) auf zumindest vier Trageelementen (18) getragen wird, die voneinander beabstandet sind, um den zu behandelnden plattenförmigen Verarbeitungsgegenstand (22) an zumindest vier Punkten zu tragen.

17. Das Verfahren gemäß einem der Ansprüche 11 bis 16, bei dem in dem ersten Betriebsmodus keine Teile der Transporteinrichtung (10) gegenüber den Kanten (22a, 22b) des plattenförmigen Verarbeitungsgegenstands (22) in einem Abstand angeordnet sind, der kleiner ist als ein Kontaktradius des Verarbeitungsmediums (72) aufgrund der Oberflächenspannung desselben.

18. Das Verfahren gemäß einem der Ansprüche 11 bis 17, bei dem in dem ersten Betriebsmodus keine Teile der Transporteinrichtung (10) gegenüber den Kanten (22a, 22b) des plattenförmigen Verarbeitungsgegenstands (22) in einem Abstand angeordnet sind, der kleiner ist als 5 mm.

19. Das Verfahren gemäß einem der Ansprüche 11 bis 18, bei dem ein Schiebeelement (20) weiter von der Endloseinrichtung (12) hervorsteht als die Trageelemente (18), wobei das Schiebeelement (20) derart von den Trageelementen (18) beabstandet ist, dass dasselbe in dem ersten Betriebsmodus nicht in mechanischem Kontakt mit den Kanten (22a, 22b) des plattenförmigen Verarbeitungsgegenstands (22) ist, wobei in einem zweiten Betriebsmodus zum Behandeln der Unterseite und der Oberseite des plattenförmigen Verarbeitungsgegenstands (22) ein relatives Senken der Trageelemente (18) relativ zu der Verarbeitungsmedienebene (24) derart ausgeführt werden kann, dass die Normalkraft zwischen Trageelementen (18) und plattenförmigem Verarbeitungsgegenstand (22) nicht ausreichend ist, um den plattenförmigen Verarbeitungsgegenstand (22) auf den Trageelementen (18) zu halten, so dass eine relative Bewegung zwischen den Trageelementen (18) und dem plattenförmigen Verarbeitungsgegenstand (22) stattfindet, durch die das Schiebeelement (20) dahin gehend mit einer Kante des plattenförmigen Verarbeitungsgegenstands (22) in Kontakt kommt, einen Transport des plattenförmigen Verarbeitungsgegenstands (22) mittels des Schiebeelements (20) zu ermöglichen.

20. Ein Verfahren zum Herstellen eines Halbleiterwafers mit einer geätzten Unterseite, das folgenden Schritt aufweist:
Durchführen eines Verfahrens gemäß einem der Ansprüche 11 bis 18, wobei der plattenförmige Verarbeitungsgegenstand (22) der Halbleiterwafer ist und wobei das Verarbeitungsmedium (72) ein Ätzmittel zum Ätzen zumindest der Unterseite des Halbleiterwafers ist.

## Revendications

1. Appareil pour traiter un article objet de traitement en forme de plaque (22) comprenant une face inférieure, une face supérieure et des bords (22a, 22b) entre la face inférieure et la face supérieure, par un milieu de traitement (72), comprenant:
un moyen (70) destiné à fournir un milieu de traitement (72) à un niveau de milieu de traitement (24);
un moyen de transport (10) comprenant un moyen sans fin (12) avec des éléments de support (18) faisant saillie de ce dernier, sur lequel peut être supportée une face inférieure de l'article objet de traitement en forme de plaque (22) à traiter, où le moyen de transport (10) est mis en œuvre pour déplacer les éléments de support (18) ensemble avec l'article objet de traitement en forme de plaque supporté (22) en parallèle avec le niveau de milieu de traitement (24) du milieu de traitement (72),
dans lequel le moyen (70) destiné à fournir le milieu de traitement (72) et le moyen de transport (10) sont adaptés pour un article objet de traitement en forme de plaque (22) à traiter de sorte que, pendant le déplacement de l'article objet de traitement en forme de plaque (22) en parallèle avec le niveau du milieu de traitement (24) du support de traitement (72), au moins les parties de la face inférieure de l'article objet de traitement en forme de plaque (22) qui ne sont pas supportées sur les éléments de support (18) soient en contact avec le milieu de traitement (72),
**caractérisé par le fait que** le moyen de transport (10) est mis en œuvre de sorte que dans un premier mode de fonctionnement, pendant le déplacement de l'article objet de traitement en forme de plaque (22) en parallèle avec le niveau du milieu de traitement (24), aucune partie du moyen de transport (10) ne vienne en prise avec les bords (22a, 22b) de l'article objet de traitement en forme de plaque (22), où le premier mode de fonctionnement correspond à un traitement d'un côté de la face inférieure de l'article objet de traitement en forme de plaque, où les bords de l'article objet de traitement en forme de plaque peuvent être traités ou non.

2. Appareil selon la revendication 1, dans lequel le moyen (70) destiné à fournir le milieu de traitement (72) et le moyen de transport (10) sont adaptés pour que l'article objet de traitement en forme de plaque (22) soit traité de sorte que les éléments de support (18) sur lesquels est supporté l'article objet de traitement (22) fassent saillie par rapport au niveau de milieu de traitement (24) pendant le premier mode de fonctionnement, de sorte que, pendant le déplacement de l'article objet de traitement en forme de plaque (22) en parallèle avec le niveau de milieu de traitement (24), un ménisque (28) soit formé entre l'article objet de traitement en forme de plaque (22) et le milieu de traitement (72), de sorte que la hauteur de jauge du milieu de traitement (72) qui est en contact avec la face inférieure de l'article objet de traitement en forme de plaque (22) se situe au-dessus du niveau de milieu de traitement (24).

3. Appareil selon la revendication 2, dans lequel le moyen (70) destiné à fournir le milieu de traitement (72) et le moyen de transport (10) sont adaptés pour que l'article objet de traitement en forme de plaque (22) soit traité de sorte que, dans le premier mode de fonctionnement, l'article objet de traitement en forme de plaque (22) soit maintenu sur les éléments de support (18) simplement par la force de son poids et la tension superficielle du milieu de traitement (72), de sorte que soit empêché un déplacement relatif entre les éléments de support (18) et l'article objet de traitement (22).

4. Appareil selon l'une des revendications 1 à 3, dans lequel les éléments de support (18) du moyen de transport (10) sont mis en œuvre pour se déplacer ensemble avec l'article objet de traitement en forme de plaque (22) pendant tout le traitement par le milieu de traitement (72).

5. Appareil selon la revendication 4, dans lequel les éléments de support (18) du moyen de transport (10) sont mis en oeuvre pour se déplacer le long d'un trajet de traitement entre la prise en charge à partir d'un appareil de transfert (80) et le transfert à un appareil de prise en charge (82) ensemble avec l'article objet de traitement en forme de plaque (22).

6. Appareil selon l'une des revendications 1 à 5, dans lequel le moyen de transport (10) comprend au moins quatre éléments de support (18) pour l'article objet de traitement en forme de plaque (22) à traiter, lesquels sont distants l'un de l'autre, pour supporter l'article objet de traitement en forme de plaque (22) à traiter en au moins quatre points.

7. Appareil selon l'une des revendications 1 à 6, dans lequel le moyen (70) destiné à fournir le milieu de traitement (72) et le moyen de transport (10) sont adaptés à l'article objet de traitement en forme de plaque (22) à traiter de sorte que, dans le premier mode de fonctionnement, pendant le déplacement de l'article objet de traitement en forme de plaque (22) en parallèle avec le niveau de milieu de traitement (24), aucune partie du moyen de transport (10) ne soit disposée opposée aux bords (22a, 22b) de l'article objet de traitement en forme de plaque (22) à une distance qui est inférieure à un rayon de contact du milieu de traitement (72) par suite de la tension superficielle de ce dernier.

8. Appareil selon l'une des revendications 1 à 7, dans lequel le moyen (70) destiné à fournir le milieu de traitement (72) et le moyen de transport (10) sont adaptés à l'article objet de traitement en forme de plaque (22) à traiter de sorte que, dans le premier mode de fonctionnement, pendant le déplacement de l'article objet de traitement en forme de plaque (22) en parallèle avec le niveau de milieu de traitement (24), aucune partie du moyen de transport (10) ne soit disposée opposée aux bords (22a, 22b) de l'article objet de traitement en forme de plaque (22) à une distance qui est inférieure à 5 mm.

9. Appareil selon l'une des revendications 1 à 8, dans lequel le moyen sans fin (12) comprend par ailleurs un élément coulissant (20) qui fait davantage saillie de ce dernier que les éléments de support (18), dans lequel l'élément coulissant (20) est distant des éléments de support (18) de sorte qu'il ne soit pas en contact mécanique avec les bords (22a, 22b) de l'article objet de traitement en forme de plaque (22) dans le premier mode de fonctionnement, dans lequel l'appareil comprend par ailleurs un moyen destiné à effectuer un abaissement relatif des éléments de support (18) par rapport au niveau de milieu de traitement (24), de sorte que, dans un deuxième mode de fonctionnement, la force normale entre les éléments de support (18) et l'article objet de traitement en forme de plaque (22) ne soit pas suffisante pour maintenir l'article objet de traitement en forme de plaque (22) sur les éléments de support (18), de sorte que se produise le déplacement relatif entre les éléments de support (18) et l'article objet de traitement en forme de plaque (22) par lequel l'élément coulissant (20) entre en contact avec un bord de l'article objet de traitement en forme de plaque (22) pour permettre le transport de l'article objet de traitement en forme de plaque (22) au moyen de l'élément coulissant (20).

10. Appareil selon l'une des revendications 1 à 9, dans lequel les éléments de support (18) comprennent des surfaces de support adaptées comme support pour l'article objet de traitement en forme de plaque (22) à traiter, dans lequel les éléments de support (18) ne comprennent aucune partie faisant saillie vers le haut au-delà de ces surfaces de support.

11. Procédé de traitement d'un article objet de traitement en forme de plaque (22) comprenant une face inférieure, une face supérieure et des bords (22a, 22b) entre la face inférieure et la face supérieure, avec un milieu de traitement (72) à l'aide d'un moyen de transport (10) comprenant un moyen sans fin (12) avec des éléments de support (18) faisant saillie de ce dernier, comprenant le fait de:
supporter une face inférieure de l'article objet de traitement en forme de plaque (22) sur des éléments de support (18) du moyen de transport (10); et
piloter le moyen de transport (10) pour déplacer les éléments de support (18) ensemble avec l'article objet de traitement en forme de plaque supporté (22) en parallèle avec un niveau de milieu de traitement (24) d'un milieu de traitement (72), où au moins les parties de la face inférieure de l'article objet de traitement en forme de plaque (22) qui ne sont pas supportées sur des éléments de support (18) sont en contact avec le milieu de traitement (72),
**caractérisé par le fait que**, dans un premier mode de fonctionnement pendant le déplacement de l'article objet de traitement en forme de plaque (22) en parallèle avec le niveau de milieu de traitement (24), aucune partie du moyen de transport (10) ne vient en prise avec les bords (22a, 22b) de l'article objet de traitement en forme de plaque (22),
dans lequel le premier mode de fonctionnement correspond à un traitement d'un côté de la face inférieure de l'article objet de traitement en forme de plaque, dans lequel les bords de l'article objet de traitement en forme de plaque peuvent être traités ou non.

12. Procédé selon la revendication 11, dans lequel les éléments de support (18) sur lesquels est supporté l'article objet de traitement (22) font saillie, dans le premier mode de fonctionnement, du niveau de milieu de traitement (24) de sorte que, pendant le déplacement de l'article objet de traitement en forme de plaque (22) en parallèle avec le niveau de milieu de traitement (24), un ménisque (28) soit formé entre l'article objet de traitement en forme de plaque (22) et le milieu de traitement (72), de sorte que la hauteur de jauge du milieu de traitement (72) qui est en contact avec la face inférieure de l'article objet de traitement en forme de plaque (22) se situe au-dessus du niveau du milieu de traitement (24).

13. Procédé selon la revendication 12, dans lequel, dans le premier mode de fonctionnement, l'article objet de traitement en forme de plaque (22) est maintenu sur les éléments de support (18) simplement par la force de son poids et la tension superficielle du milieu de traitement (72), de sorte que soit empêché un déplacement relatif entre les éléments de support (18) et l'article objet de traitement (22).

14. Procédé selon l'une des revendications 1 à 13, dans lequel les éléments de support (18) du moyen de transport (10) sont déplacés ensemble avec l'article objet de traitement en forme de plaque (22) pendant tout le traitement par le milieu de traitement (72).

15. Procédé selon la revendication 14, dans lequel les éléments de support (18) du moyen de transport (10) sont déplacés le long d'un trajet de traitement entre la prise en charge d'un appareil de transfert (80) et le transfert à un appareil de prise en charge (82) ensemble avec l'article objet de traitement en forme de plaque (22).

16. Procédé selon l'une des revendications 11 à 15, dans lequel l'article objet de traitement en forme de plaque (22) est supporté sur au moins quatre éléments de support (18) qui sont distants l'un de l'autre, pour supporter l'article objet de traitement en forme de plaque (22) à traiter en au moins quatre points.

17. Procédé selon l'une des revendications 11 à 16, dans lequel, dans le premier mode de fonctionnement, aucune partie du moyen de transport (10) n'est disposée opposée aux bords (22a, 22b) de l'article objet de traitement en forme de plaque (22) à une distance qui est inférieure à un rayon de contact du milieu de traitement (72) par suite de la tension superficielle de ce dernier.

18. Procédé selon l'une des revendications 11 à 17, dans lequel, dans le premier mode de fonctionnement, aucune partie du moyen de transport (10) n'est disposée opposée aux bords (22a, 22b) de l'article objet de traitement en forme de plaque (22) à une distance inférieure à 5 mm.

19. Procédé selon l'une des revendications 11 à 18, dans lequel un élément coulissant (20) fait davantage saillie du moyen sans fin que les éléments de support (18), dans lequel l'élément coulissant (20) est distant des éléments de support (18) de sorte qu'il ne soit pas en contact mécanique avec les bords (22a, 22b) de l'article objet de traitement en forme de plaque (22) dans le premier mode de fonctionnement, dans lequel, dans un deuxième mode de fonctionnement, pour traiter la face inférieure et la face supérieure de l'article objet de traitement en forme de plaque (22), un abaissement relatif des éléments de support (18) par rapport au niveau de milieu de traitement (24) peut être effectué, de sorte que la force normale entre les éléments de support (18) et l'article objet de traitement en forme de plaque (22) ne soit pas suffisante pour maintenir l'article objet de traitement en forme de plaque (22) sur les éléments de support (18), de sorte que se produise le déplacement relatif entre les éléments de support (18) et l'article objet de traitement en forme de plaque (22) par lequel l'élément coulissant (20) entre en contact avec un bord de l'article objet de traitement en forme de plaque (22) pour permettre le transport de l'article objet de traitement en forme de plaque (22) au moyen de l'élément coulissant (20).

20. Procédé de production d'une plaquette semi-conductrice avec une face inférieure gravée, comprenant le fait de:
réaliser un procédé selon l'une des revendications 11 à 18, dans lequel l'article objet de traitement en forme de plaque (22) est la plaquette semi-conductrice, et dans lequel le milieu de traitement (72) est un agent de gravure destiné à graver au moins la face inférieure de la plaquette semi-conductrice.
